Europäisches Patentamt

European Patent Office

Office européen des brevets

(11) Veröffentlichungsnummer: **0 429 943 A1**

## (12) EUROPÄISCHE PATENTANMELDUNG

(21) Anmeldenummer: 90121688.7

(22) Anmeldetag: **13.11.90**

(51) Int. Cl.⁵: **H01R 43/01**

(30) Priorität: **01.12.89 DE 3939775**

(43) Veröffentlichungstag der Anmeldung:
**05.06.91 Patentblatt 91/23**

(84) Benannte Vertragsstaaten:
**DE FR IT SE Patentblatt**

(71) Anmelder: **STOCKO Metallwarenfabriken Henkels und Sohn GmbH & Co**
**Kirchhofstrasse 52a**
**W-5600 Wuppertal 1(DE)**

(72) Erfinder: **Kübelstein, Lutz**
**Laternbergerschulweg 5**
**W-5600 Wuppertal 1(DE)**
Erfinder: **Ströter, Hermann**
**Hilgershöhe 42**
**W-5600 Wuppertal 2(DE)**
Erfinder: **Manigel, Heinz**
**Filscherweg 6**
**W-5600 Wuppertal 11(DE)**

(74) Vertreter: **Patentanwälte Dipl.-Ing. Alex Stenger Dipl.-Ing. Wolfram Watzke Dipl.-Ing. Heinz J. Ring**
**Kaiser-Friedrich-Ring 70**
**W-4000 Düsseldorf 11(DE)**

(54) **Vorrichtung für die Restbestückung von vorbestückten Kabelbäumen.**

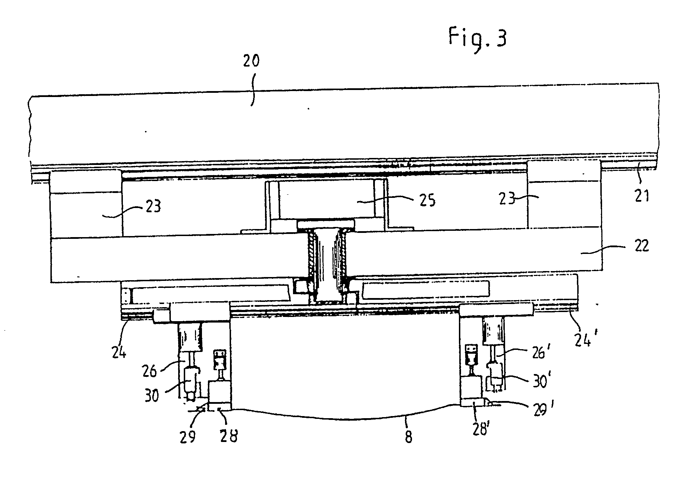

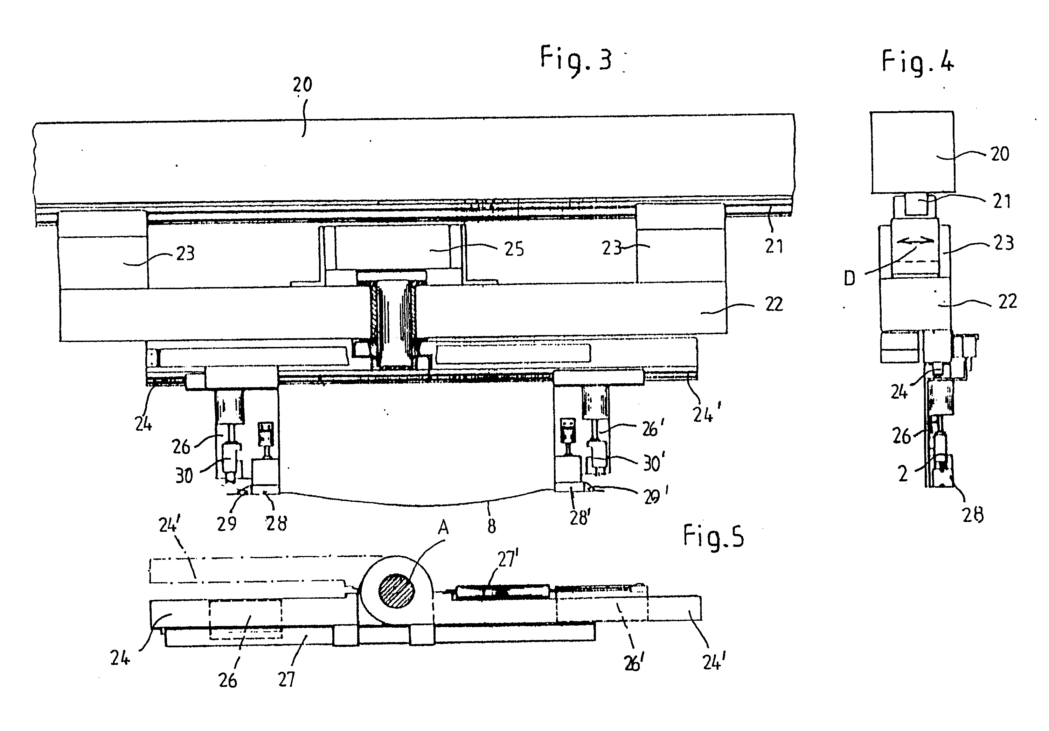

(57) Eine Vorrichtung für die Restbestückung von mit zueinander parallelen Kabeln 8 vorbestückten Kabelbäumen 1 durch die nicht parallelen Kabel 8 im Rastersprung, über Kreuz und/oder als Brücke zur Herstellung von elektrischen Kabelverbindungen mit endseitig kontaktierten elektrischen Steckverbindern 2 weist zwei unabhängig voneinander arbeitende Arbeitswerkzeuge 26,26' auf, die unabhängig voneinander jeweils mittels eines Positionierantriebs längsverfahrbar an einer Trägerschiene 24,24' angeordnet sind. Zwischen diesen Arbeitswerkzeugen 26,26' ist das jeweils zu kontaktierende und auf die richtige Länge abgelenkte Kabel 8 festlegbar. Die Trägerschienen 24,24' sind weiterhin querverschiebbar und können darüber hinaus zur Brückenbildung ausgehend von einer gestreckten Ausgangsposition um 180° gegeneinander horizontal verschwenkbar sein. Die Trägerschienen 24,24' sind schließlich an einem Portal 20 angeordnet, längs dessen Schiene 21 sie an einer gemeinsamen Trägerleiste 22 verfahrbar sind. (Fig. 3)

EP 0 429 943 A1

Fig. 3

## VORRICHTUNG FÜR DIE RESTBESTÜCKUNG VON VORBESTÜCKTEN KABELBÄUMEN

Die Erfindung betrifft eine Vorrichtung für die Restbestückung von mit zueinander parallelen Kabeln vorbestückten Kabelbäumen durch die nicht parallelen Kabel im Rastersprung, über Kreuz und/oder als Brücke zur Herstellung von elektrischen Kabelverbindungen mit endseitig kontaktierten elektrischen Steckverbindern, die Vorrichtung mit zwei unabhängig voneinander arbeitenden Arbeitswerkzeugen für das jeweils zu verarbeitende Kabel, wobei das eine Arbeitswerkzeug bezüglich zum anderen Arbeitswerkzeug mittels eines Positionierantriebs längsverfahrbar an einer Trägerschiene angeordnet ist und wobei zwischen den beiden Arbeitswerkzeugen das jeweils zu verarbeitende, mittels einer separaten Vorrichtung zugeführte sowie auf die richtige Länge abgelängte Kabel festlegbar ist.

Kabelbäume bestehen aus einer Mehrzahl von elektrischen Kabeln, welche endseitig an elektrischen Steckverbindern kontaktiert sind. Mittels derartiger Kabelbäume lassen sich elektrische Kabelverbindungen zwischen elektronischen Bauelementen schaffen. Aus der DE-PS 32 23 086 ist dabei ein Kabelbaum bekannt, bei dem zwischen zwei mehrpoligen Steckverbindern die Kabel parallel verlaufen.

Ein Problem stellt die Herstellung von Kabelbäumen dar, wenn die Kabel nicht ausschließlich parallel zueinander verlaufen, sondern stattdessen teilweise einen Rastersprung aufweisen, über Kreuz verlaufen und/oder Brücken bilden (DE-OS 33 40 744). Um derartige Kabelbäume mit nicht parallelen Kabeln herzustellen, ist es bekannt, auf einem Legebrett die zu kontaktierenden elektrischen Steckverbinder sowie darüber hinaus sogenannte Verlegehilfen anzuordnen. Ein Arbeitswerkzeug, welches an einem heb- und senkbaren Gelenkarm angeordnet ist, führt dabei das jeweils zu kontaktierende Kabel um die Verlegehilfen herum zu den entsprechenden Kontaktierstellen der elektrischen Steckverbinder. Dies ist jedoch technisch aufwendig und vor allem wenig wirtschaftlich, da beispielsweise für die Erstellung eines neuen Kabelbaumes die elektrischen Steckverbinder sowie vor allem die Verlegehilfen neu auf dem Verlegebrett positioniert werden müssen.

Aus der US-PS 4 043 017 ist die Vorrichtung der eingangs angegebenen Art für die Bestückung von Kabelbäumen bekannt, wobei es mittels dieser Vorrichtung neben dem parallelen Verlauf der Kabel des Kabelbaumes auch möglich ist, diese im Rastersprung zu verlegen und sie endseitig mit dem entsprechenden elektrischen Steckverbinder zu kontaktieren. Zu diesem Zweck weist die Vorrichtung zwei unabhängig voneinander arbeitende Arbeitswerkzeuge auf. Dabei ist das eine Arbeitswerkzeug fest und das andere Arbeitswerkzeug längsverfahrbar an einer Trägerschiene angeordnet, um auf diese Weise unterschiedlich lange Kabelbäume herstellen zu können. Um mittels dieser Bestückungsvorrichtung Rastersprünge realisieren zu können, ist dem feststehenden Arbeitswerkzeug eine Platte mit oberseitigen Führungsrillen zugeordnet, in die die Kabelenden geführt werden. Entsprechend dem Verlauf der Führungsrillen werden dann die Kabel entsprechend dem Rastersprung den entsprechenden Kontakten des elektrischen Steckverbinders zugeordnet.

Die Möglichkeiten mit dieser Bestückungsvorrichtung sind sehr eingeschränkt. Zwar ist es möglich, Rastersprünge bei der Kontaktierung der elektrischen Steckverbinder zu realisieren, doch ist für jede Anordnung eine eigene Führungsplatte notwendig. Dies ist technisch aufwendig. Die Herstellung von elektrischen Kabelverbindungen mit über Kreuz und/oder als Brücke geführten Kabeln ist mit dieser bekannten Bestückungsvorrichtung nachteiligerweise jedoch nicht möglich. Weiterhin können zwar unterschiedlich lange Kabelbäume hergestellt werden, doch ist es nicht möglich, daß die einzelnen Kabel des jeweiligen Kabelbaumes unterschiedliche Längen aufweisen.

Davon ausgehend liegt der Erfindung die **Aufgabe** zugrunde, die bekannte Bestückungsvorrichtung dahingehend weiterzuentwickeln, daß außer dem Verlauf der Kabel im Rastersprung diese auch über Kreuz und/oder als Brücke an den elektrischen Steckverbindern kontaktiert werden können.

Als technische **Lösung** wird mit der Erfindung vorgeschlagen, daß beide Arbeitswerkzeuge unabhängig voneinander jeweils mittels eines Positionierantriebs längsverfahrbar an der Trägerschiene angeordnet sind und daß die beiden Trägerschienen mit ihren Arbeitswerkzeugen querverschiebbar sind sowie darüber hinaus ausgehend von einer gestreckten Ausgangsposition, bei der die beiden Trägerschienen hintereinander liegend die gegenseitige Fortsetzung bilden, derart um 180° gegeneinander horizontal verschwenkbar sind, daß sie nach ihrem Verschwenken parallel nebeneinander liegen.

Mittels einer derartigen Vorrichtung lassen sich die kompliziertesten Kabelbäume auf technisch einfache Weise verfahrensmäßig herstellen. In einer der erfindungsgemäßen Vorrichtung vorgeordneten Vorrichtung erfolgt zunächst eine Vorbestückung der Kabelbäume mit den zueinander parallelen Kabeln. Die erfindungsgemäße Vorrichtung dient dann der Restbestückung mit den nicht parallelen Kabeln, welche beispielsweise einen Rastersprung aufweisen, über Kreuz geführt sind und/oder eine Brücke bilden. All diese Kabelsonderverlegungen lassen sich mit der er findungsgemäßen Restbestückungsvorrichtung auf einfache Weise herstellen. Die beiden Arbeitswerkzeuge können dabei jeweils Einrichtungen zum Zuführen des jeweils zu verarbeitenden Kabels, zum Festklemmen dieses Kabels sowie schließlich zum Ansetzen des Kabels an den jeweils zu kontaktierenden Pol des entsprechenden elektrischen Steckverbinders aufweisen. Durch die Klemmeinrichtung kann das auf die richtige Länge abgelängte Kabel mittels der beiden Arbeitswerkzeuge problemlos in die entsprechende Kontaktierposition verfahren werden. Durch die Querverschiebbarkeit der Trägerschienen mit ihren Arbeitswerkzeugen kann dabei der entsprechende Pol angesteuert werden, während die gegenseitige Verschwenkbarkeit der beiden Trägerschienen der Brückenbildung dient, also wenn ein Kabel an ein und demselben elektrischen Steckverbinder, jedoch zwischen unterschiedlichen Polen kontaktiert werden soll.

In einer Weiterbildung ist zum Zuführen des jeweils zu verarbeitenden Kabels dieses durch tunnelartige Kabelführungen in den beiden Arbeitswerkzeugen hindurchgeführt, wobei den Kabelführungen jeweils eine Klemmeinrichtung zugeordnet ist. Diese Klemmeinrichtung kann beispielsweise aus Klemmbacken bestehen. Auf diese Weise ist eine problemlose Zufuhr des jeweils zu verarbeitenden Kabels von einem separaten Kabelsequenzer möglich, indem das eine Kabelende durch die Kabelführungen der beiden Arbeitswerkzeuge hindurchgeführt wird.

Um auf technisch einfache Weise die Arbeitswerkzeuge längs ihrer Trägerschienen verfahren zu können, sind vorzugsweise Verfahrzylinder vorgesehen. Diese können beispielsweise vom kolbenstangenlosen Typ sein.

In einer Weiterbildung wird vorgeschlagen, daß bei gestreckter Position der beiden Trägerschienen jedes der beiden Arbeitswerkzeuge beide Trägerschienen durchfahren kann. Auf diese Weise können die beiden Arbeitswerkzeuge auf einer maximalen Länge verfahren werden, so daß die Einsatzmöglichkeiten im Hinblick auf eine optimale und technisch einfach durchzuführende Bestückung weiter verbessert sind. Insbesondere wird die Reichweite der auf den Trägerschienen verfahrbaren Arbeitswerkzeuge verdoppelt.

Um die beiden Trägerschienen auf technisch einfache Weise gegeneinander verschwenken zu können, ist vorzugsweise ein Drehzylinder vorgesehen.

In einer bevorzugten Weiterbildung sind die beiden Trägerschienen für die Arbeitswerkzeuge vorzugsweise an einer gemeinsamen Trägerleiste angeordnet, die ihrerseits zusammen mit den Trägerschienen sowie den Arbeitswerkzeugen mittels eines Positionierantriebs längs einer an einem Portal angeordneten Schiene verfahrbar ist. Die Länge dieser Portalbrücke mit der Schiene entspricht dabei der maximalen Kabelbaumlänge. Diese Portalbrücke mit ihrer Schiene hat den Vorteil, daß die Arbeitswerkzeuge längs dieser Brücke zu den jeweiligen Kontaktierpositionen verfahren werden können, ohne daß die Arbeitswerkzeuge längs ihrer Trägerschienen verfahren werden müssen, so daß sich diese Trägerschienen relativ kurz ausbilden lassen.

Um die Positionierbarkeit der beiden Arbeitswerkzeuge weiter zu verbessern, wird in einer Weiterbildung vorgeschlagen, daß das Portal oder die Trägerleiste quer zu der Schiene verschiebbar ist.

Dabei ist vorzugsweise die eine Trägerschiene fest an der Trägerleiste und die andere Trägerschiene verschwenkbar an der Trägerleiste angeordnet, so daß sich eine technisch einfache Verschwenkkonstruktion ergibt.

Schließlich wird in einer Weiterbildung vorgeschlagen, daß die Arbeitswerkzeuge jeweils einen Kontaktierstempel aufweisen, der vorzugsweise pneumatisch betrieben wird. Dies hat den Vorteil, daß die Arbeitswerkzeuge selbst mit der Kontaktiereinrichtung ausgestattet sind, so daß der Kontaktierstempel auf präzise Weise gegenüber dem zu kontaktierenden Kabelende positioniert ist. Darüber hinaus ist dadurch keine separate Kontaktierstation notwendig, die ansonsten mit einem eigenen Positionierantrieb versehen sein müßte.

Ein Ausführungsbeispiel einer erfindungsgemäßen Restbestückungsvorrichtung für die nicht parallelen Kabel eines vorbestückten Kabelbaumes wird nachfolgend anhand der Zeichnungen beschrieben. In diesen zeigt:

Fig. 1     eine schematische Ansicht eines Kabelbaumes, der sowohl mit zueinander parallelen als auch mit nicht parallelen Kabeln bestückt ist;

Fig. 2     eine schematische Draufsicht auf eine Gesamtvorrichtung für die Bestückung von Kabelbäumen;

Fig. 3     die Restbestückungsvorrichtung aus der Gesamtvorrichtung in Fig. 2 in einer Ansicht von vorne;

Fig. 4     die Restbestückungsvorrichtung in Fig. 3 in einer Seitenansicht;

Fig. 5     die Restbestückungsvorrichtung in Fig. 3 in einer Draufsicht auf die Trägerschienen unterhalb der Trägerleiste.

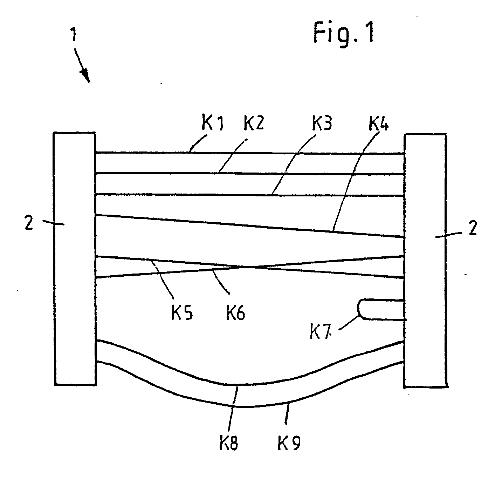

In Fig. 1 ist rein schematisch ein Kabelbaum 1 dargestellt. Dieser besteht aus Kabeln K1 bis K9, welche endseitig an elektrischen Steckverbindern 2 kontaktiert sind.

Während die drei obersten Kabel K1 bis K3 parallel zueinander verlaufen, führt das Kabel K4 einen Rastersprung auf, d.h. im rechten elektrischen Steckverbinder wird ein Pol übersprungen. Die Kabel K5 und K6 verlaufen über Kreuz, während das Kabel K7 eine Brücke bildet, bei welcher das Kabel K7 bei ein und demselben elektrischen Steckverbinder 2 zwei Pole miteinander verbindet. Die beiden letzten Kabel K8 und K9 schließlich besitzen eine Überlänge und hängen etwas durch.

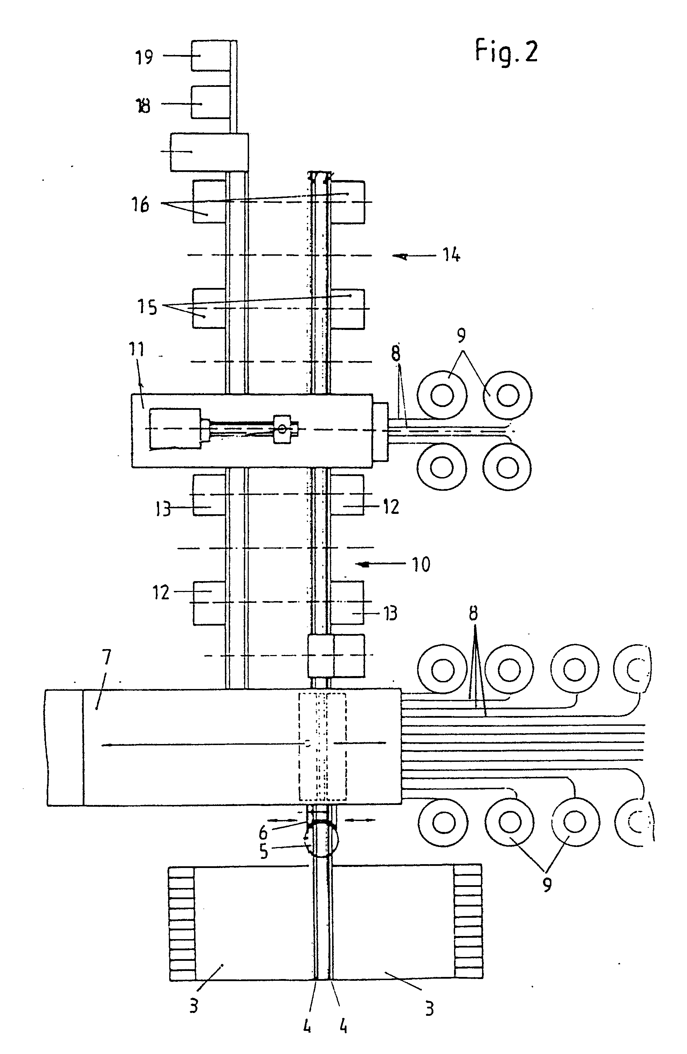

Ein derartiger Kabelbaum 1 läßt sich in einer Gesamtvorrichtung herstellen, wie sie in Fig. 2 dargestellt ist. Diese Gesamtvorrichtung weist zunächst zwei Steckverbinderzuführungen 3 auf, mittels welcher die elektrischen Steckverbinder 2 Zuführschienen 4 aufgegeben werden. Die elektrischen Steckverbinder 2 der linken Steckverbinderzuführung 3 weisen dabei eine andere Profilierung auf wie die elektrischen Steckverbinder 2 der rechten Steckverbinderzuführung 3, d.h. auf den beiden Seiten ist die Profilierung der elektrischen Steckverbinder 2 jeweils gleich, jedoch können sie unterschiedliche Polzahlen besitzen. Entsprechend sind die Zuführschienen 4 profiliert.

Der Transport der elektrischen Steckverbinder 2 innerhalb der Zuführschienen 4 erfolgt mittels Transportvorrichtungen beispielsweise in Form von Schiebern.

Im Anschluß an die Zuführschienen 4 folgt eine Drehscheibe 5, mittels welcher ein Wechsel der elektrischen Steckverbinder 2 von der einen Seite zur anderen möglich ist, um so die unterschiedlichsten Steckverbinderkombinationen herstellen zu können. Der Drehscheibe 5 hinwiederum folgt eine Doppelführungsschiene 6 mit entsprechend den beiden Steckverbinderprofilierungen vorgesehenen Schienenprofilierungen, damit jeder elektrische Steckverbinder 2 auf jeder der beiden Seiten transportiert werden kann.

Es folgt eine Parallelbestückungsvorrichtung, mittels der die zugeführten elektrischen Steckverbinder mit Kabeln 8 kontaktiert werden, die parallel zueinander verlaufen. Rechts von der Parallelbestückungsvorrichtung 7 ist dabei der Kabelvorrat in Form von Kabelfässern 9 angedeutet. Die Parallelbestückungsvorrichtung 7 kann dabei eine Bestückung mit Kabeln 8 einer ganz bestimmten Länge vornehmen.

Der Parallelbestückungsvorrichtung 7 folgt eine Transferstrecke 10 zu einer Restbestückungsvorrichtung 11, welche nachfolgend anhand der Fig. 3 bis 5 noch näher beschrieben werden wird. In die Transferstrecke 10 sind dabei Stationen 12 und 13 geschaltet, welche weitere Arbeiten ausführen. Rechts von der Restbestückungsvorrichtung 11 ist ebenfalls ein Kabelvorrat für die Kabel 8 in Form von Kabelfässern 9 erkennbar.

Der Restbestückungsvorrichtung 11 folgt schließlich eine Auslaufstrecke 14, der weitere Stationen 15 bis 19 zugeordnet sind, welche zur Fertigstellung des endgültigen Kabelbaumes 1 weitere Arbeiten durchführen.

Die bereits erwähnte Restbestückungsvorrichtung 11 weist zunächst ein Portal 20 auf, welches die Breite der Transferstrecke 10 überspannt. Dieses Portal 20 weist unterseitig eine Schiene 21 auf.

Auf dieser Schiene 21 ist unterseitig eine Trägerleiste 22 an Verschiebestücken 23 längsverschiebbar, und zwar mittels eines nicht dargestellten Positionierantriebs. An der Unterseite dieser Trägerleiste 22 ist eine Trägerschiene 24 fest angeordnet, während eine weitere Trägerschiene 24' um eine senkrechte Achse A mittels eines Drehzylinders 25 um 180° verschwenkbar ist. In Fig. 5 ist dabei mit durchgezogenen Linien die gestreckte Stellung der beiden Trägerschienen 24,24' dargestellt, während strichpunktiert die Trägerschiene 24' nach dem Verschwenken um 180° dargestellt ist.

An der Unterseite jeder der beiden Trägerschienen 24,24' ist ein Arbeitswerkzeug 26,26' mittels eines Positionierantriebes längsverfahrbar angeordnet. Zum Verfahren der beiden Arbeitswerkzeuge 26,26' dienen Verfahrzylinder 27,27'. Die beiden Arbeitswerkzeuge 26,26' weisen jeweils eine Kabelführung 28,28' mit einer zugeordneten, jedoch nicht dargestellten Klemmeinrichtung auf. Diesen Kabelführungen 28,28' ist jeweils eine Führungsspitze 29,29' zugeordnet. Schließlich weisen die beiden Arbeitswerkzeuge 26,26' noch Kontaktierstempel 30,30' auf, die pneumatisch betrieben werden und dem Kontaktieren der Kabelenden an die entsprechenden elektrischen Steckverbinder 2 dienen.

Die Restbestückungsvorrichtung 11 arbeitet wie folgt:

In der Grund- und Ausgangsposition sind die beiden Trägerschienen 24,24' gestreckt, also in der in Fig. 5 dargestellten Position mit durchgezogenen Linien. Das Arbeitswerkzeug 26 fährt an das Arbeitswerkzeug 26' heran, also in der Zeichnung von links nach rechts, bis das Arbeitswerkzeug 26 am Arbeitswerkzeug 26' anstößt. Die Führungsspitze 29' der Kabelführung 28' des rechten Arbeitswerkzeuges 26' dockt dabei an einem Kabelsequenzer mit entsprechender Schneideinheit sowie Längenmeßeinrichtung an. Dieser Kabelsequenzer ist in der Zeichnung nicht dargestellt.

Aus dem Kabelsequenzer wird das Kabel 8 durch (ebenfalls nicht dargestellte) Transportwalzen in die beiden Kabelführungen 28,28' transportiert, und zwar durchläuft es zunächst die Kabelführung 28' des rechten Arbeitswerkzeuges 26', bis es die linke Kabelführung 28 des linken Arbeitswerkzeugs 26 erreicht.

In der linken Kabelführung 28 wird das Kabel 8 mittels der entsprechenden Klemmeinrichtung festgeklemmt, während das Kabel 8 in der rechten Kabelführung 28 noch nicht festgeklemmt ist. Mit dem so festgeklemmt auf Kabel 8 wird das linke Arbeitswerkzeug 26 ans Ende der Trägerschiene 24 nach links verfahren und nimmt dabei das Kabel 8 mit. Anschließend wird das Kabel 8 entsprechend der vorgegebenen Kabellänge durch die Transportwalzen weitertransportiert. Nach Erreichen der vorgegebenen Länge wird das Kabel 8 in der rechten Kabelführung 28 festgeklemmt, abgeschnitten und durch die Führungsspitze 29' gesichert.

Durch Verfahren der Trägerleiste 22 längs der Schiene 21 des Portals 20 und/oder des Portals 20 selbst wird das linke Arbeitswerkzeug 26 vor den zu kontaktierenden Pol des entsprechenden elektrischen Steckverbinders 2 verfahren, nachdem zusätzlich noch gegebenenfalls eine Querverschiebung entweder der Trägerleiste 22 oder des Portals 20 erfolgt ist. Dies ist in Fig. 4 rein schematisch durch den Doppelpfeil D angedeutet, ohne die entsprechende Querverschiebeeinrichtung darzustellen. In der vorgegebenen Stellung wird somit das linke Ende des Kabels 8 kontaktiert und durch Öffnen der Klemmeinrichtung und Anheben der Kabelführung 28 aus dem Arbeitswerkzeug 26 entlassen.

Auf die entsprechende Art und Weise wird das rechte Arbeitswerkzeug 26' vor den zu kontaktierenden Pol des rechten elektrischen Steckverbinders 2 verfahren.

Soll mittels des Kabels 8 eine sogenannte Brücke hergestellt werden, also eine Verbindung von Polen auf der gleichen Seite, so wird vor dem Kontaktieren des rechten Endes des Kabels 8 mittels des rechten Arbeitswerkzeugs 26' die rechte Trägerschiene 24' zunächst mittels des Drehzylinders 25 um 180° verschwenkt, so daß die Trägerschiene 24' sich parallel mit Abstand zur Trägerschiene 24 erstreckt.

Nach dem Kontaktieren fahren sämtliche Stationen in ihre Ausgangsstellung zurück und die parallele Bestückungsvorrichtung 7 insgesamt vor den Kabelsequenzer, so daß ein neues Kabel 8 aufgenommen und kontaktiert werden kann.

### Bezugszeichenliste

| | |
|---|---|
| 1 | Kabelbaum |
| 2 | elektrischer Steckverbinder |
| 3 | Steckverbinderzuführung |
| 4 | Zuführschiene |
| 5 | Drehscheibe |
| 6 | Doppelführungsschiene |
| 7 | Parallelbestückungsvorrichtung |
| 8 | Kabel |
| 9 | Kabelfass |
| 10 | Transferstrecke |
| 11 | Restbestückungsvorrichtung |
| 12 | Station |
| 13 | Station |
| 14 | Auslaufstrecke |
| 15 | Station |
| 16 | Station |
| 17 | Station |
| 18 | Station |
| 19 | Station |
| 20 | Portal |
| 21 | Schiene |
| 22 | Trägerleiste |
| 23 | Verschiebestück |
| 24,24' | Trägerschiene |
| 25 | Drehzylinder |
| 26,26' | Arbeitswerkzeug |
| 27,27' | Verfahrzylinder |
| 28,28' | Kabelführung |
| 29,29' | Führungsspitze |
| 30,30' | Kontaktierstempel |
| K1 bis K9 | Kabel |
| A | Achse |
| D | Doppelpfeil |

### Ansprüche

1. Vorrichtung für die Restbestückung von mit zueinander parallelen Kabeln (8) vorbestückten Kabelbäumen (1) durch die nicht parallelen Kabel (8) im Rastersprung, über Kreuz und/oder als Brücke zur Herstellung von elektrischen Kabelverbindungen mit endseitig kontaktierten elektrischen Steckverbindern (2), die Vorrichtung mit zwei unabhängig voneinander arbeitenden Arbeitswerkzeugen (26,26') für das jeweils zu verarbeitende Kabel (8), wobei das eine Arbeitswerkzeug (26) bezüglich zum anderen Arbeitswerkzeug (26') mittels eines Positionierantriebs längsverfahrbar an einer Trägerschiene (24,24') angeordnet ist und wobei zwischen den beiden Arbeitswerkzeugen (26,26') das jeweils zu verarbeitende, mittels einer separaten Vorrichtung zugeführte sowie auf die richtige Länge abgelängte Kabel (8) festlegbar ist, **dadurch gekennzeichnet,** daß beide Arbeitswerkzeuge (26,26') unabhängig voneinander jeweils mittels eines Positionierantriebs längsverfahrbar an der Trägerschiene (24,24') angeordnet sind und daß die beiden Trägerschienen (24,24') mit ihren Arbeitswerkzeugen (26,26') querverschiebbar sind sowie darüber hinaus ausgehend von einer gestreckten Ausgangsposition, bei der die beiden Trägerschienen (24,24') hintereinander liegend die gegenseitige Fortsetzung bilden, derart um 180° gegeneinander horizontal verschwenkbar sind, daß sie nach ihrem Verschwenken parallel nebeneinander liegen.

2. Vorrichtung nach Anspruch 1, dadurch gekennzeichnet, daß zum Zuführen des jeweils zu verarbeitenden Kabels (8) dieses durch tunnelartige Kabelführungen (28,28') in den beiden Arbeitswerkzeugen (26,26') hindurchführbar ist, wobei den Kabelführungen (28,28') jeweils eine Klemmeinrichtung zugeordnet ist.

3. Vorrichtung nach Anspruch 1 oder 2, dadurch gekennzeichnet, daß zum Verfahren der Arbeitswerkzeuge (26,26') längs der Trägerschienen (24,24') jeweils Verfahrzylinder (27,27') vorgesehen sind.

4. Vorrichtung nach einem der Ansprüche 1 bis 3, dadurch gekennzeichnet, daß bei gestreckter Position der beiden Trägerschienen (24,24') jedes der beiden Arbeitswerkzeuge (26,26') beide Trägerschienen (24,24') durchfahren kann.

5. Vorrichtung nach einem der Ansprüche 1 bis 4, dadurch gekennzeichnet, daß zum Verschwenken der beiden Trägerschienen (24,24') gegeneinander ein Drehzylinder (25) vorgesehen ist.

6. Vorrichtung nach einem der Ansprüche 1 bis 5, dadurch gekennzeichnet, daß die beiden Trägerschienen (24,24') für die Arbeitswerkzeuge (26,26') an einer gemeinsamen Trägerleiste (22) angeordnet sind, die ihrerseits zusammen mit den Trägerschienen (24,24') sowie den Arbeitswerkzeugen (26,26') mittels eines Positionierantriebs längs einer an einem Portal (20) angeordneten Schiene (21) verfahrbar ist.

7. Vorrichtung nach Anspruch 6, dadurch gekennzeichnet, daß das Portal (20) oder die Trägerleiste (22) quer zu der Schiene (21) verschiebbar ist.

8. Vorrichtung nach Anspruch 6 oder 7, dadurch gekennzeichnet, daß die eine Trägerschiene (24) fest an der Trägerleiste (22) und die andere Trägerschiene (24') verschwenkbar an der Trägerleiste (22) angeordnet ist.

9. Vorrichtung nach einem der Ansprüche 1 bis 8, dadurch gekennzeichnet, daß die Arbeitswerkzeuge (26,26') jeweils einen Kontaktierstempel (30,30') aufweisen.

Fig.1

Fig. 2

Fig. 3

Fig. 3

Fig. 4

Fig. 5

EP 0 429 943 A1

**Europäisches Patentamt**

# EUROPÄISCHER RECHERCHENBERICHT

Nummer der Anmeldung

**EP 90 12 1688**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 642 873 (BOWER JR. ET AL.) <br> * Spalte 6, Zeilen 39 - 64; Figur 5 * <br> — — — | 1-3 | H 01 R <br> 43/01 |
| A | EP-A-0 109 735 (AMP) <br> * Seite 2, Zeile 19 - Seite 3, Zeile 6 * <br> — — — | 1,5 | |
| A,D | DE-A-3 340 744 (ARTOS ENGINEERING CO.) <br> * Zusammenfassung; Figuren 10, 22 * <br> — — — — — | 1-2,6 | |

| RECHERCHIERTE SACHGEBIETE (Int. Cl.5) |
|---|
| H 01 R <br> H 05 K |

Der vorliegende Recherchenbericht wurde für alle Patentansprüche erstellt

| Recherchenort | Abschlußdatum der Recherche | Prüfer |
|---|---|---|
| Den Haag | 08 März 91 | SIBILLA S.E. |